# EUROPÄISCHE PATENTSCHRIFT

(11) **EP 3 286 829 B1**
(45) Veröffentlichungstag und Bekanntmachung des Hinweises auf die Patenterteilung: **20.03.2019**
(21) Anmeldenummer: 16717666.8
(22) Anmeldetag: 22.04.2016
(51) Int. Cl.: H02M 3/335, H02M 1/32, H02M 1/34

(54) **GLEICHSPANNUNGSWANDLER**
DC-DC CONVERTER
CONVERTISSEUR CONTINU-CONTINU

(30) Priorität: 24.04.2015 DE 102015207605
(43) Veröffentlichungstag der Anmeldung: 28.02.2018
(73) Patentinhaber: Schmidhauser AG, 8590 Romanshorn (CH)
(72) Erfinder: SCHEKULIN, Dirk, 9056 Gais (CH)
(74) Vertreter: Patentanwälte Ruff, Wilhelm, Beier, Dauster & Partner mbB
(86) Internationale Anmeldenummer: PCT/EP2016/059059
(87) Internationale Veröffentlichungsnummer: WO 2016/170142

(56) Entgegenhaltungen:
- DE-A1-102012 219 365
- US-A1- 2005 024 803
- US-A1- 2013 223 104

## Beschreibung

### Anwendungsgebiet und Stand der Technik

Die Erfindung betrifft einen Gleichspannungswandler.

Bei Gleichspannungswandlern (auch als Gleichstromsteller bezeichnet), beispielsweise in Form von Gegentaktflusswandlern, entstehen infolge der Streuinduktivitäten der üblicherweise verwendeten Transformatoren in Verbindung mit dem Kommutierungsverhalten der sekundärseitigen Gleichrichterdioden Schaltüberspannungen an den Leistungshalbleitem, die ohne Begrenzung zur Zerstörung der Leistungshalbleiter führen würden oder eine extreme Überdimensionierung der Spannungsfestigkeit erfordern würden.

Herkömmlich werden zur Bedämpfung der Schaltüberspannungen RC-Glieder parallel zu den Gleichrichterdioden der Gleichspannungswandler geschaltet. Nachteilig hierbei ist die entstehende Verlustwärme in den Bedämpfungswiderständen. Je nach Strombelastung, Schaltenergie, Temperatur, usw. können dadurch erhebliche Entwärmungsprobleme auftreten, die zu einer Limitierung des erzielbaren Ausgangsstroms führen können.

Die US 2013/0223104 A1 zeigt einen Gleichspannungswandler, der einen Ausgangsanschluss aufweist, wobei der Ausgangsanschluss einen ersten Ausgangsanschlusspol und einen zweiten Ausgangsanschlusspol aufweist. Der Gleichspannungswandler weist weiter eine Anzahl von Gleichrichterelementen und eine Spannungsbegrenzungseinheit mit einem elektrischen Energiespeicher auf, wobei die Spannungsbegrenzungseinheit dazu ausgebildet ist, Spannungen an den Gleichrichterelementen zu begrenzen. Der Gleichspannungswandler weist weiter eine getaktete Energiereglereinheit auf, die dazu ausgebildet ist, in dem elektrischen Energiespeicher gespeicherte Energie auf einen Soll-Wert zu regeln.

Auch aus der US 2005/0024803 ist ein Gleichspannungswandler mit einer Spannungsbegrenzungseinheit und einer Energiereglereinheit bekannt.

Die DE 10 2012 219 365 A1 zeigt einen Gleichspannungswandler mit einem Transformator, der eine erste Primärwicklung und eine zweite Primärwicklung aufweist. Die Primärwicklungen werden mittels einer ersten getakteten Halbbrückenschaltung und mittels einer zweiten getakteten Halbbrückenschaltung angesteuert.

### Aufgabe und Lösung

Der Erfindung liegt die Aufgabe zugrunde, einen Gleichspannungswandler (auch als DC-DC-Wandler bezeichnet) zur Verfügung zu stellen, der einen wirksamen Schutz Schaltüberspannungen gewährleistet und der gleichzeitig möglichst wenig elektrische Verluste erzeugt.

Die Erfindung löst diese Aufgabe durch einen Gleichspannungswandler nach Anspruch 1.

Die Erfindung betrifft einen Gleichspannungswandler, insbesondere in Form eines Gegentaktflusswandlers. Der Gleichspannungswandler kann unidirektional oder bidirektional ausgebildet sein.

Der Gleichspannungswandler weist einen Ausgangsanschluss auf, wobei der Ausgangsanschluss einen ersten Ausgangsanschlusspol (Plus-Pol) und einen zweiten Ausgangsanschlusspol (Minus-Pol) aufweist. An dem ersten Ausgangsanschlusspol kann ein höheres Potential anliegen als an dem zweiten Ausgangsanschlusspol. Der Begriff "Ausgang" ist hierbei nicht dahingehend einschränkend zu verstehen, dass es sich zwingend um einen unidirektionalen Gleichspannungswandler mit einem dedizierten Eingang und Ausgang handeln muss. Bei einem bidirektionalen Gleichspannungswandler ist der Ausgangsanschluss einer der beiden (nicht gerichteten) äußern Anschlüsse.

Der Gleichspannungswandler weist weiter eine Anzahl (beispielsweise zwischen 2 und 4) von Gleichrichterelementen auf.

Der Gleichspannungswandler weist weiter eine, insbesondere passive, Spannungsbegrenzungseinheit (Überspannungsschutzeinheit) auf. Die Spannungsbegrenzungseinheit ist dazu ausgebildet, (Über-)Spannungen an den Gleichrichterelementen zu begrenzen bzw. zu reduzieren. Die Spannungsbegrenzungseinheit weist einen elektrischen Energiespeicher auf, der dazu ausgebildet ist, Energie, die von Spannungsspitzen aufgrund von Schaltvorgängen herrührt, zumindest teilweise zu puffern.

Der Gleichspannungswandler weist weiter eine mit der Spannungsbegrenzungseinheit gekoppelte, getaktete Energiereglereinheit auf, die dazu ausgebildet ist, in dem elektrischen Energiespeicher gespeicherte Energie bzw. eine an dem Energiespeicher anstehende Spannung zu begrenzen und/oder auf einen Sollwert zu regeln, indem die Energiereglereinheit beispielsweise Energie, die in dem Energiespeicher gespeichert ist, in Richtung des Ausgangsanschlusses überträgt, wenn die in dem Energiespeicher gespeicherte Energie einen Energie-Sollwert überschreitet bzw. eine an dem Energiespeicher anstehende Spannung einen Spannungs-Sollwert überschreitet. Die Energiereglereinheit kann ein getaktetes Schaltmittel aufweisen, wobei ein Takt des Schaltmittels von einem Betriebstakt des Gleichspannungswandlers abweichen kann.

Die Energiereglereinheit ermöglicht es, Schaltenergie regenerativ beispielsweise an dem Ausgangsanschluss zur Verfügung zu stellen, ohne dass die Schaltenergie dissipativ in einem Widerstand in Wärme umgewandelt wird. Gleichzeitig ist eine wirksame Überspannungsbegrenzung sichergestellt.

Die getaktete Energiereglereinheit weist einen (getakteten) Gleichstromsteller (kann allgemein auch als getakteter Steiler bezeichnet werden), beispielsweise in Form eines Inverswandlers, auf, der dazu ausgebildet ist, in dem elektrischen Energiespeicher gespeicherte Energie in Richtung des Ausgangsanschlusses zu übertragen. Der Gleichstromsteller kann als Stellglied im Kontext der Energie- bzw. Spannungsregelung fungieren, beispielsweise indem er nur dann Energie in Richtung des Ausgangsanschlusses überträgt, wenn die in dem elektrischen Energiespeicher gespeicherte Energie einen Sollwert überschreitet. Der Gleichstromsteller kann beispielsweise ein invertierender oder ein nicht invertierender Tiefsetzsteller oder Hochsetzsteller sein.

Der Gleichspannungswandler weist einen, beispielsweise galvanisch trennenden, Transformator auf. Der Transformator weist, neben einer, zwei oder mehreren Primärwicklungen, mindestens eine Sekundärwicklung auf, wobei die Gleichrichterelemente dazu ausgebildet sind, eine oder mehrere Spannungen an der mindestens einen Sekundärwicklung gleichzurichten.

Der Transformator weist eine erste Sekundärwicklung und eine zweite Sekundärwicklung auf, wobei die Gleichrichterelemente dazu ausgebildet sind, Spannungen an der ersten und der zweiten Sekundärwicklung gleichzurichten.

Die Gleichrichterelemente können Dioden sein. Die Gleichrichterelemente können alternativ auch Transistoren sein, beispielsweise MOSFETs, wodurch eine Synchrongleichrichtung möglich wird.

Der Gleichspannungswandler weist ein induktives Bauelement auf, beispielsweise in Form einer Spule oder Drossel. Ein erster Anschluss der ersten Sekundärwicklung und ein erster Anschluss der zweiten Sekundärwicklung sind mit dem zweiten Ausgangsanschlusspol elektrisch mittelbar (mit weiteren zwischengeschalteten Bauelementen) oder unmittelbar (ohne weitere zwischengeschaltete Bauelementen) verbunden. Das erste Gleichrichterelement und das induktive Bauelement sind zwischen einen zweiten Anschluss der ersten Sekundärwicklung und den ersten Ausgangsanschlusspol eingeschleift. Das zweite Gleichrichterelement ist zwischen einen zweiten Anschluss der zweiten Sekundärwicklung und einen Verbindungsknoten des ersten Gleichrichterelements und des induktiven Bauelements eingeschleift.

Die Spannungsbegrenzungseinheit weist eine erste Diode und eine zweite Diode auf. Der elektrische Energiespeicher ist ein Kondensator bzw. weist einen solchen auf. Die Anode der ersten Diode und die Anode der zweiten Diode sind elektrisch mit einem ersten Anschluss des Kondensators verbunden. Die Kathode der ersten Diode ist mit dem zweiten Anschluss der ersten Sekundärwicklung elektrisch verbunden. Die Kathode der zweiten Diode ist mit dem zweiten Anschluss der zweiten Sekundärwicklung elektrisch verbunden. Ein zweiter Anschluss des Kondensators ist mit einem Verbindungsknoten des ersten Gleichrichterelements, des zweiten Gleichrichterelements und des induktiven Bauelements elektrisch verbunden.

Die Energiereglereinheit weist eine Entkopplungsdiode und einen Ladungstransferkondensator auf. Die Kathode der Entkopplungsdiode ist mit der Anode der ersten Diode und der Anode der zweiten Diode elektrisch verbunden. Ein erster Anschluss des Ladungstransferkondensators ist mit der Anode der Entkopplungsdiode elektrisch verbunden. Ein zweiter Anschluss des Ladungstransferkondensators ist mit dem zweiten Ausgangsanschlusspol elektrisch verbunden. Ein erster Eingangsanschlusspol des Gleichstromstellers ist mit der Kathode der Entkopplungsdiode elektrisch verbunden. Ein zweiter Eingangsanschlusspol des Gleichstromstellers ist mit dem ersten Anschluss der ersten Sekundärwicklung, dem ersten Anschluss der zweiten Sekundärwicklung und dem zweiten Ausgangsanschlusspol elektrisch verbunden.

Der Transformator kann mindestens eine Primärwicklung aufweisen. Der Gleichspannungswandler kann mindestens eine getaktete Halbbrückenschaltung aufweisen, die dazu ausgebildet ist, die mindestens eine Primärwicklung mit einer zeitlich veränderlichen Spannung oder einem zeitlich veränderlichen Strom zu beaufschlagen. Für diesen Fall ist der Gleichspannungswandler (bzw. eine Steuereinheit des Gleichspannungswandlers) dazu ausgebildet, eine Schaltfrequenz der mindestens einen Halbbrückenschaltung unabhängig von einer Schaltfrequenz der getakteten Energiereglereinheit bzw. des Gleichstromstellers einzustellen und/oder Schaltphasen der mindestens einen Halbbrückenschaltung unabhängig von Schaltphasen der getakteten Energiereglereinheit bzw. des Gleichstromstellers einzustellen. Beispielsweise kann die Halbbrückenschaltung eine Pulsweitenmodulation durchführen und die Energiereglereinheit kann ebenfalls eine Pulsweitenmodulation durchführen, wobei sowohl die jeweiligen Periodendauern als auch die jeweiligen Tastverhältnisse der Pulsweitenmodulation voneinander unabhängig einstellbar sind.

Der Transformator kann eine erste Primärwicklung und eine zweite Primärwicklung aufweisen. Der Gleichspannungswandler kann eine erste getaktete Halbbrückenschaltung und eine zweite getaktete Halbbrückenschaltung aufweisen, wobei die erste getaktete Halbbrückenschaltung dazu ausgebildet ist, die erste Primärwicklung mit einer zeitlich veränderlichen Spannung oder einem zeitlich veränderlichen Strom zu beaufschlagen und die zweite getaktete Halbbrückenschaltung dazu ausgebildet ist, die zweite Primärwicklung mit einer zeitlich veränderlichen Spannung oder einem zeitlich veränderlichen Strom zu beaufschlagen. Der Gleichspannungswandler ist für diesen Fall dazu ausgebildet, eine Schaltfrequenz der ersten getakteten Halbbrückenschaltung und der zweiten getakteten Halbbrückenschaltung unabhängig von einer Schaltfrequenz der getakteten Energiereglereinheit bzw. des Gleichstromstellers einzustellen und/oder Schaltphasen der ersten getakteten Halbbrückenschaltung und der zweiten getakteten Halbbrückenschaltung unabhängig von Schaltphasen der getakteten Energiereglereinheit bzw. des Gleichstromstellers einzustellen.

### Kurzbeschreibung der Zeichnungen

Die Erfindung wird nachfolgend detailliert unter Bezugnahme auf die Zeichnungen beschrieben. Hierbei zeigen:
- Fig. 1: ein Schaltbild eines Teils eines erfindungsgemäßen Gleichspannungswandlers gemäß einer ersten Ausführungsform,
- Fig. 2: ein Schaltbild eines Teils eines erfindungsgemäßen Gleichspannungswandlers gemäß einer weiteren Ausführungsform,
- Fig. 3: ein Schaltbild eines Teils eines nicht zur Erfindung gehörenden Gleichspannungswandlers,
- Fig. 4: ein Schaltbild eines Teils eines nicht zur Erfindung gehörenden Gleichspannungswandlers,
- Fig. 5: ein Schaltbild einer primärseitigen Transformatorbeschaltung des in Fig. 1 gezeigten Gleichspannungswandlers,
- Fig. 6: ein Blockschaltbild einer Steuersignal-Generierung,
- Fig. 7: zeitliche Strom-Verläufe durch unterschiedliche Drosseln des Gleichspannungswandlers und
- Fig. 8: einen zeitlichen Strom-Verlauf durch eine Drossel eines Gleichstromstellers des Gleichspannungswandlers.

### Detaillierte Beschreibung der Ausführungsformen

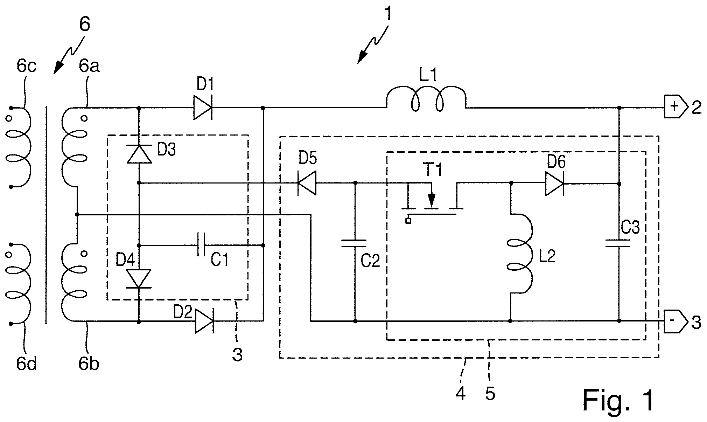

Fig. 1 zeigt ein Schaltbild einer Sekundärseite eines erfindungsgemäßen Gleichspannungswandlers oder Flusswandlers 1 gemäß einer ersten Ausführungsform. Der Gleichspanungswandler 1 kann beispielsweise als Bordnetzwandler in einem Kraftfahrzeug verwendet werden.

Der Gleichspannungswandler 1 weist einen (Ausgangs-) Anschluss auf, wobei der Ausgangsanschluss einen ersten (Ausgangs-) Anschlusspol 2 und einen zweiten (Ausgangs-) Anschlusspol 3 aufweist. Zwischen den Anschlusspolen 2 und 3 liegt beispielsweise eine Bornetzspannung von 24 V DC oder 48 V DC an.

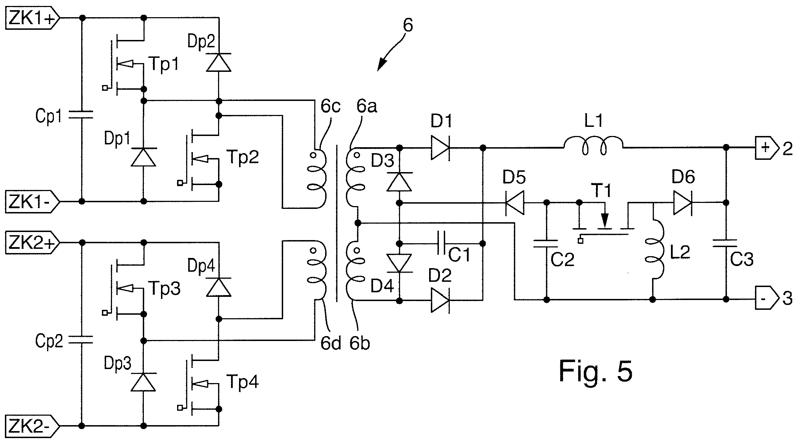

Der Gleichspannungswandler 1 weist zwei Gleichrichterelemente in Form von zwei Dioden D1 und D2 auf. Die Dioden D1 und D2 dienen dazu, Spannungen an Sekundärwicklungen 6a und 6b eines Transformators 6 gleichzurichten. Die Primärwicklungen 6c und 6d des Transformators 6 werden herkömmlich mit Wechselspannungen beaufschlagt, die beispielsweise aus einer Zwischenkreisspannung mit einem Pegel von 400 V DC oder 800 V DV erzeugt werden. Insoweit sei auch auf Fig. 5 verwiesen.

Der Gleichspannungswandler 1 weist weiter eine passive Spannungsbegrenzungseinheit oder Klemmschaltung 3 mit einem elektrischen Energiespeicher in Form eines Kondensators C1 und Dioden D3 und D4 auf. Die Anode der Diode D3 und die Anode der Diode D4 sind elektrisch mit einem ersten Anschluss des Kondensators C1 verbunden. Die Kathode der Diode D3 ist mit dem zweiten Anschluss der ersten Sekundärwicklung 6a elektrisch verbunden. Die Kathode der Diode D4 ist mit dem zweiten Anschluss der zweiten Sekundärwicklung elektrisch verbunden. Ein zweiter Anschluss des Kondensators C1 ist mit einem Verbindungsknoten der Diode D1 und der Diode D2 elektrisch verbunden. Die Spannungsbegrenzungseinheit 3 ist dazu ausgebildet, Spannungen an den Gleichrichterdioden D1 und D2 zu begrenzen.

Der Gleichspannungswandler 1 weist weiter eine Energiereglereinheit 4 auf, die dazu ausgebildet ist, in dem Kondensator C1 gespeicherte Energie zu begrenzen bzw. auf einen Sollwert zu regeln, indem überschüssige Energie in Richtung der Anschlusspole 2 und 3 übertragen wird, wo sie beispielsweise von einem nicht näher dargestellten elektrischen Verbraucher aufgenommen werden kann.

Hierzu weist die Energiereglereinheit 4 einen Gleichstromsteller (kann auch als Steller bezeichnet werden) in Form eines spannungsinvertierenden Tiefsetzstellers (Inverswandlers) 5 auf, der dazu ausgebildet ist, in dem elektrischen Energiespeicher C1 gespeicherte Energie in Richtung der Anschlusspole 2 und 3 zu übertragen.

Der Gleichspannungswandler 1 weist weiter ein induktives Bauelement in Form einer Spule oder Drossel L1 auf, wobei ein erster Anschluss der ersten Sekundärwicklung 6a und ein erster Anschluss der zweiten Sekundärwicklung 6b (Mittenabgriff des Transformators 6) mit dem zweiten Ausgangsanschlusspol 3 elektrisch verbunden sind.

Die Diode D1 in Durchlassrichtung und das induktive Bauelement L1 sind zwischen einen zweiten Anschluss der ersten Sekundärwicklung 6a und den ersten Ausgangsanschlusspol 2 eingeschleift. Die Diode D2 ist in Durchlassrichtung zwischen einen zweiten Anschluss der zweiten Sekundärwicklung 6b und einen Verbindungsknoten der Diode D1 und der Spule L1 eingeschleift.

Die Energiereglereinheit 4 weist weiter eine Entkopplungsdiode D5 und einen Ladungstransferkondensator C2 auf. Die Kathode der Entkopplungsdiode D5 ist mit der Anode der Diode D3 und der Anode der Diode D4 sowie einem Anschluss des Kondensators C1 elektrisch verbunden. Ein erster Anschluss des Ladungstransferkondensators C2 ist mit der Anode der Entkopplungsdiode D5 elektrisch verbunden. Ein zweiter Anschluss des Ladungstransferkondensators C2 ist mit dem zweiten Ausgangsanschlusspol 3 und dem Mittenabgriff des Transformators 6 elektrisch verbunden.

Ein erster Eingangsanschlusspol des Tiefsetzstellers 5 ist mit der Anode der Entkopplungsdiode D5 elektrisch verbunden und ein zweiter Eingangsanschlusspol des Tiefsetzstellers 5 ist mit dem ersten Anschluss der ersten Sekundärwicklung 6a, dem ersten Anschluss der zweiten Sekundärwicklung 6b (Mittenabgriff des Transformators 6) und dem zweiten Ausgangsanschlusspol 3 elektrisch verbunden.

Die Bauelemente D3, D4 und C1 der Spannungsbegrenzungseinheit 3 bilden eine passive Klemmschaltung zur sicheren Spannungsbegrenzung der Gleichrichterdioden D1 und D2. Die Energie aus dem Kommutierungsvorgang wird dabei auf dem Kondensator C1 gespeichert.

Mit Hilfe der Diode D5 erfolgt eine Entkopplung der Potentiale der Klemmschaltung 3 zum Kondensator C2. Sowohl C1 als auch C2 tragen in etwa die doppelte Sekundärspannung des Transformators 6.

Der nachgeschaltete Abwärts- oder Inverswandler 5 aufweisend Bauelemente in Form eines Transistors T1, einer Spule bzw. Drossel L2 und einer Diode D6 hält die Spannung über dem Kondensator C2 und damit auch über dem Kondensator C1 konstant und kann asynchron zur Taktfrequenz des Leistungspfades des Flusswandlers 1 arbeiten und beispielsweise mit einer Schaltfrequenz zwischen 50 und 100 kHz betrieben werden. Damit wird die in der Klemmschaltung 3 entstehende bzw. vorhandene Energie verlustarm auf die Ausgangsseite transferiert und in einem Kondensator C3 gepuffert.

Die Überspannungsbegrenzung erfolgt mit einem robusten passiven Netzwerk. Die Schaltkreise für Überspannungsklemmung und Rückspeisung sind funktional über die Diode D5 entkoppelt. Damit ist eine getrennte Optimierung der jeweiligen Bauelemente möglich.

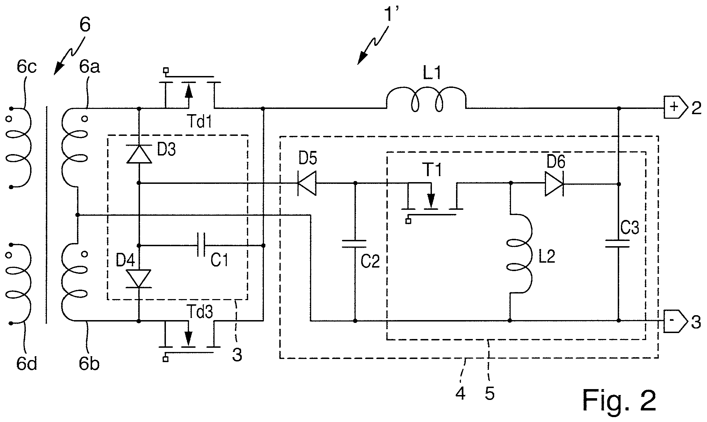

Fig. 2 zeigt ein Schaltbild einer Sekundärseite eines erfindungsgemäßen Gleichspannungswandlers oder Flusswandlers 1' gemäß einer weiteren Ausführungsform.

Verglichen mit der in Fig. 1 gezeigten Ausführungsform sind lediglich die Dioden D1 und D2 durch MOSFETs Td1 und Td3 ersetzt, wodurch eine Synchron-Gleichrichtung und ein bidirektionaler Gleichspannungswandlerbetrieb möglich werden.

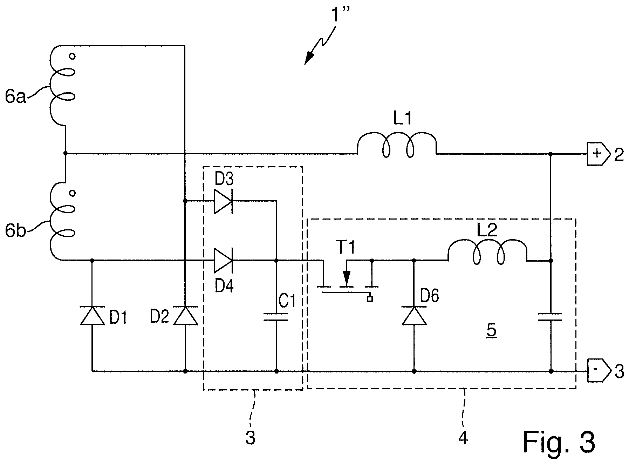

Fig. 3 zeigt ein Schaltbild einer Sekundärseite eines Gleichspannungswandlers oder Flusswandlers 1".

Bei dieser Ausführungsform sind die Kathode der Diode D3 und die Kathode der Diode D4 mit dem ersten Anschluss des Kondensators C1 elektrisch verbunden. Die Anode der Diode D3 ist mit dem zweiten Anschluss der ersten Sekundärwicklung 6a elektrisch verbunden. Die Anode der Diode D4 ist mit dem zweiten Anschluss der zweiten Sekundärwicklung 6b elektrisch verbunden. Der zweite Anschluss des Kondensators C1 ist mit dem zweiten Ausgangsanschlusspol 3 elektrisch verbunden

Ein erster Eingangsanschlusspol der Energiereglereinheit 4 bzw. des Tiefsetzstellers 5 ist mit der Kathode der Diode D3, der Kathode der Diode D4 und dem ersten Anschluss des Kondensators C1 elektrisch verbunden. Ein zweiter Eingangsanschlusspol des Tiefsetzstellers 5 ist mit den jeweiligen Anoden der Dioden D1 und D2, dem zweiten Anschluss des Kondensators C1 und dem zweiten Ausgangsanschlusspol 3 elektrisch verbunden.

Bei der in Fig. 3 gezeigten Ausführungsform können die Dioden D2 und D3 wie in Fig. 2 durch Transistoren ersetzt werden.

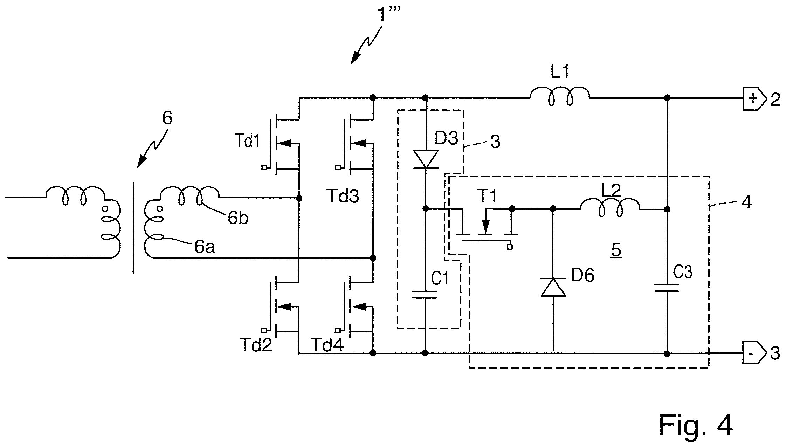

Fig. 4 zeigt ein Schaltbild einer Sekundärseite eines Gleichspannungswandlers oder Flusswandlers 1"'. Der Gleichspannungswandler 1'" kann beispielsweise in einem 48 V Bordnetz verwendet werden, wohingegen die in den Figuren 1 bis 3 gezeigten Ausführungsformen bevorzugt in 24 V Bordnetzen Verwendung finden.

Bei dem Gleichspannungswandler 1'" sind die beiden Sekundärwicklungen 6a und 6b in Reihe geschaltet. Zur Erzeugung der 48 V Ausgangsspannung wird ein Synchron-Brückengleichrichter aufweisend die MOSFETs Td1 bis Td4 verwendet. Die in C1 gespeicherte Kommutierungsenergie kann direkt in den Ausgangskondensator C3 mittels des Tiefsetzstellers 5 übertragen werden, da kein Mittenpotential" vorhanden ist. Anstelle der MOSFETs Td1 bis Td4 können auch Dioden verwendet werden, falls keine Synchrongleichrichtung und kein bidirektionaler Betrieb notwendig sind.

Die erfindungsgemäße Spannungsbegrenzungseinheit dient zur Spannungsbegrenzung, wobei die "geklemmte" Energie in einem Kondensator C1 zwischengespeichert wird und über den Tiefsetzsteller 5 der Sekundärseite (Verbraucherseite) zur Verfügung gestellt wird. Auf diese Weise kann eine regenerative Überspannungs-Klemmung anstelle einer Überspannungs-Bedämpfung realisiert werden.

Es versteht sich, dass je nach vorherrschenden Spannungsniveaus und Schaltungstopologie anstelle des Tiefsetzstellers 5 ein anderer geeigneter Gleichstromsteller verwendet werden kann.

Fig. 5 zeigt ein Schaltbild einer primärseitigen Transformatorbeschaltung des in Fig. 1 gezeigten Gleichspannungswandlers 1. Es versteht sich, dass die dargestellte primärseitige Transformatorbeschaltung auch in den Ausführungsformen der Figuren 2 bis 4 verwendet werden kann.

Die zwei unabhängigen Primärwicklungen 6c und 6d werden von einer ersten asymmetrischen Halbbrückenschaltung Tp1, Tp2, Dp1, Dp2, Cp1 bzw. einer zweiten asymmetrischen Halbbrückenschaltung Tp3, Tp4, Dp3 Dp4, Cp2 angesteuert, wobei der Index p primärseitig bezeichnet.

Die Halbleiterschalter bzw. Transistoren Tp1 und Tp2 bzw. Tp3 und Tp4 der jeweiligen Halbbrücke werden synchron angesteuert, d.h. Tp1 und Tp2 werden gleichzeitig ein-/ausgeschaltet und Tp3 und Tp4 werden gleichzeitig ein-/ausgeschaltet. Die beiden Halbbrücken werden vorzugsweise 180 Grad phasenversetzt gegeneinander getaktet. Die Halbbrücken können seriell oder parallel verschaltet werden. Bei Parallelschaltung ist eine identische Windungszahl der Primärwicklungen erforderlich. Die Größen ZK1 + und ZK2+ bezeichnen positive Zwischenkreispotentiale und die Größen ZK1- und ZK2- bezeichnen negative Zwischenkreispotentiale.

Nachfolgend wird der Betrieb der Energiereglereinheit 4 bzw. des Gleichstromstellers 5 näher beschrieben.

Der Gleichstromsteller 5 dient nicht zur Verringerung des Summenausgangsstroms und der Verringerung der Baugröße des Ausgangskondensators C3, sondern zur regenerativen Überspannungs-Klemmung anstelle einer Überspannungs-Bedämpfung.

Der Gleichstromsteller 5 wird hierbei unabhängig vom Hauptsteller (aufweisend unter anderem die primärseitigen Halbbrücken, den Transformator 6, die Gleichrichterelemente D1 und D2 und das induktive Bauelement bzw. die Drossel L1) betrieben.

Beispielsweise kann der Ausgangsstrom des Gleichstromstellers 5 bzw. der Drosselstrom durch L2 völlig unabhängig vom Strom durch L1 gewählt werden, insbesondere unabhängig von Stromschwankungen des Stroms durch L1.

Weiter kann eine Schaltfrequenz des Transistors T1 unabhängig von einer Schaltfrequenz der Halbleiterschalter Tp1 bis Tp4 sein.

Weiter können Schaltphasen des Transistors T1 unabhängig von Schaltphasen der Halbleiterschalter Tp1 bis Tp4 sein.

Der Gleichstromsteller 5 wird bevorzugt mit einem kontinuierlichen Stromfluss durch die Drossel L2 betrieben. Diese Betriebsweise ermöglicht eine minimale Baugröße der Drossel L2 des Gleichstromstellers. Weiter ermöglicht diese Betriebsweise reduzierte Verluste in den Halbleitern T1 und D6 infolge günstigem Verhältnis von AV- und RMS-Strömen [AV = arithmetischer Mittelwert; RMS = quadratischer Mittelwert] und somit eine reduzierte Baugröße des gesamten Gleichstromstellers 5.

In einem unteren Teillastbereich wird der Gleichstromsteller 5 entweder im diskontinuierlichen Bereich oder im Aussetzmodus betrieben. Ein synchroner Betrieb ist auch in diesem Fall nicht erforderlich.

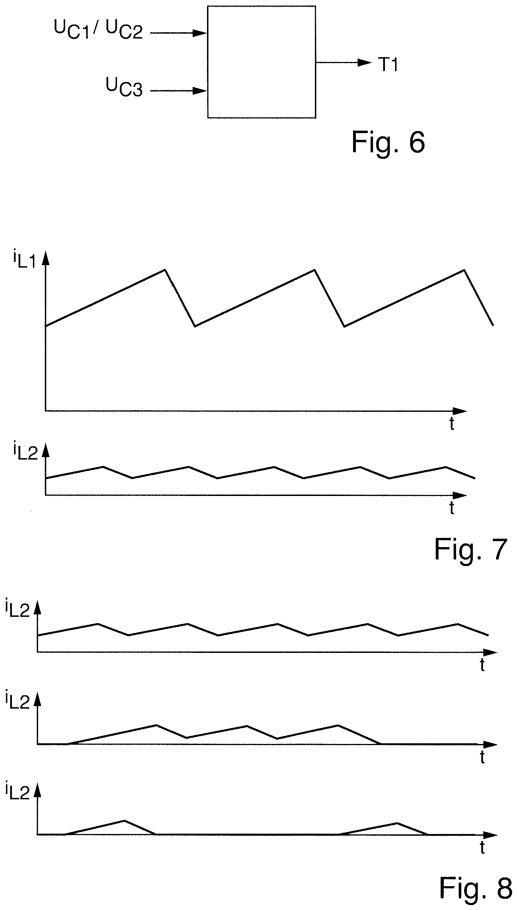

Bezugnehmend auf Fig. 6 ist das einzige Regelkriterium für den Abwärts- bzw. Inverswandler 5 eine Spannung über dem (Spannungsbegrenzungs-) Kondensator C1 oder eine Eingangsspannung des Gleichstromstellers (Spannung über C1 bzw. C2) und eine Spannung über dem Kondensator C3.

Im kontinuierlichen Betriebsmodus kann das Spannungsumsetzungsverhältnis des Gleichstromstellers 5 über ein Tastverhältnis des Ansteuersignals von T1 eingestellt werden.

Fig. 7 zeigt zeitliche Strom-Verläufe durch die Drosseln L1 bzw. L2 des Gleichspannungswandlers unter Volllast. Wie aus Fig. 7 hervorgeht, verlaufen die Ströme asynchron bzw. zufällig zueinander, da der Transistor T1 unabhängig von den Transistoren Tp1 und Tp2 bzw. Tp3 und Tp4 der primärseitigen Halbbrücken getaktet wird.

Fig. 8 den zeitlichen Strom-Verlauf durch die Drossel L2 für verschiedene Lastfälle, d.h. oben einen Betrieb unter Volllast, in der Mitte einen Betrieb unter Teillast im Aussetzbetrieb und unten einen Betrieb unter Teillast im Lückbetrieb.

Ein mittlerer Strom durch L1 ist typischer Weise 200 A im Volllastfall. Ein Strom durch L2 hingegen typischer Weise 10 A im Volllastfall.

## Patentansprüche

1. Gleichspannungswandler (1, 1', 1", 1'"), aufweisend:
- einen Ausgangsanschluss, wobei der Ausgangsanschluss einen ersten Ausgangsanschlusspol (2) und einen zweiten Ausgangsanschlusspol (3) aufweist,
- eine Anzahl von Gleichrichterelementen (D1, D2; Td1, Td2),
- eine Spannungsbegrenzungseinheit (3) mit einem elektrischen Energiespeicher (C1), wobei die Spannungsbegrenzungseinheit (3) dazu ausgebildet ist, Spannungen an den Gleichrichterelementen (D1, D2; Td1, Td2) zu begrenzen,
- eine getaktete Energiereglereinheit (4), die dazu ausgebildet ist, in dem elektrischen Energiespeicher (C1) gespeicherte Energie auf einen Sollwert zu regeln, wobei die getaktete Energiereglereinheit (4) einen Gleichstromsteller (5) aufweist, der dazu ausgebildet ist, in dem elektrischen Energiespeicher (C1) gespeicherte Energie zum Ausgangsanschluss zu übertragen,
- einen Transformator (6) mit einer ersten Sekundärwicklung (6a) und einer zweiten Sekundärwicklung (6b), wobei die Gleichrichterelemente (D1, D2; Td1, Td2) dazu ausgebildet sind, Spannungen an der ersten Sekundärwicklung (6a) und der zweiten Sekundärwicklung (6b) gleichzurichten,
- ein induktives Bauelement (L1), **dadurch gekennzeichnet, dass**
- ein erster Anschluss der ersten Sekundärwicklung (6a) und ein erster Anschluss der zweiten Sekundärwicklung (6b) mit dem zweiten Ausgangsanschlusspol (3) elektrisch verbunden sind,
- wobei ein erstes Gleichrichterelement (D1) und das induktive Bauelement (L1) zwischen einen zweiten Anschluss der ersten Sekundärwicklung (6a) und den ersten Ausgangsanschlusspol (2) eingeschleift sind, und
- wobei ein zweites Gleichrichterelement (D2) zwischen einen zweiten Anschluss der zweiten Sekundärwicklung (6b) und einen Verbindungsknoten des ersten Gleichrichterelements (D1) und des induktiven Bauelements (L1) eingeschleift ist,
- wobei die Spannungsbegrenzungseinheit (3) aufweist:
- eine erste Diode (D3) und
- eine zweite Diode (D4),
- wobei der elektrische Energiespeicher (C1) ein Kondensator ist,
- wobei die Anode der ersten Diode (D3) und die Anode der zweiten Diode (D4) elektrisch mit einem ersten Anschluss des Kondensators (C1) verbunden sind,
- wobei die Kathode der ersten Diode (D3) mit dem zweiten Anschluss der ersten Sekundärwicklung (6a) elektrisch verbunden ist,
- wobei die Kathode der zweiten Diode (D4) mit dem zweiten Anschluss der zweiten Sekundärwicklung (6b) elektrisch verbunden ist, und
- wobei ein zweiter Anschluss des Kondensators (C1) mit einem Verbindungsknoten des ersten Gleichrichterelements (D1), des zweiten Gleichrichterelements (D2) und des induktiven Bauelements (L1) elektrisch verbunden ist,
- wobei die Energiereglereinheit (4) eine Entkopplungsdiode (D5) und einen Ladungstransferkondensator (C2) aufweist,
- wobei die Kathode der Entkopplungsdiode (D5) mit der Anode der ersten Diode (D3) und der Anode der zweiten Diode (D4) elektrisch verbunden ist,
- wobei ein erster Anschluss des Ladungstransferkondensators (C2) mit der Anode der Entkopplungsdiode (D5) elektrisch verbunden ist,
- wobei ein zweiter Anschluss des Ladungstransferkondensators (C2) mit dem zweiten Ausgangsanschlusspol (3) elektrisch verbunden ist,
- wobei ein erster Eingangsanschlusspol des Gleichstromstellers (5) mit der Anode der Entkopplungsdiode (D5) elektrisch verbunden ist, und
- wobei ein zweiter Eingangsanschlusspol des Gleichstromstellers (5) mit dem ersten Anschluss der ersten Sekundärwicklung (6a), dem ersten Anschluss der zweiten Sekundärwicklung (6b) und dem zweiten Ausgangsanschlusspol (3) elektrisch verbunden ist.

2. Gleichspannungswandler (1, 1', 1", 1"') nach einem der vorhergehenden Ansprüche, **dadurch gekennzeichnet, dass**
- die Gleichrichterelemente (D1, D2; Td1, Td2) Dioden oder Transistoren sind.

3. Gleichspannungswandler (1, 1', 1", 1"') nach Anspruch 1 oder 2, **dadurch gekennzeichnet, dass**
- der Transformator (6) mindestens eine Primärwicklung (6c, 6d) aufweist und
- der Gleichspannungswandler (1, 1', 1", 1"') mindestens eine getaktete Halbbrückenschaltung (Tp1, Tp2, Dp1, Dp2; Tp3, Tp4, Dp3, Dp4) aufweist, die dazu ausgebildet ist, die mindestens eine Primärwicklung (6c, 6d) mit einer zeitlich veränderlichen Spannung oder einem zeitlich veränderlichen Strom zu beaufschlagen,
- wobei der Gleichspannungswandler (1, 1', 1", 1"') dazu ausgebildet ist, eine Schaltfrequenz der mindestens einen Halbbrückenschaltung (Tp1, Tp2, Dp1, Dp2; Tp3, Tp4, Dp3, Dp4) unabhängig von einer Schaltfrequenz der getakteten Energiereglereinheit (4) einzustellen und/oder Schaltphasen der mindestens einen Halbbrückenschaltung (Tp1, Tp2, Dp1, Dp2; Tp3, Tp4, Dp3, Dp4) unabhängig von Schaltphasen der getakteten Energiereglereinheit (4) einzustellen.

4. Gleichspannungswandler (1, 1', 1", 1'") nach Anspruch 1 oder 2, **dadurch gekennzeichnet, dass**
- der Transformator (6) eine erste Primärwicklung (6c) und eine zweite Primärwicklung (6d) aufweist und
- der Gleichspannungswandler (1, 1', 1", 1"') eine erste getaktete Halbbrückenschaltung (Tp1, Tp2, Dp1, Dp2) und eine zweite getaktete Halbbrückenschaltung (Tp3, Tp4, Dp3, Dp4) aufweist, wobei die erste getaktete Halbbrückenschaltung (Tp1, Tp2, Dp1, Dp2) dazu ausgebildet ist, die erste Primärwicklung (6c) mit einer zeitlich veränderlichen Spannung oder einem zeitlich veränderlichen Strom zu beaufschlagen und die zweite getaktete Halbbrückenschaltung (Tp3, Tp4, Dp3, Dp4) dazu ausgebildet ist, die zweite Primärwicklung (6d) mit einer zeitlich veränderlichen Spannung oder einem zeitlich veränderlichen Strom zu beaufschlagen,
- wobei der Gleichspannungswandler (1, 1', 1", 1"') dazu ausgebildet ist, eine Schaltfrequenz der ersten getakteten Halbbrückenschaltung (Tp1, Tp2, Dp1, Dp2) und der zweiten getakteten Halbbrückenschaltung (Tp3, Tp4, Dp3, Dp4) unabhängig von einer Schaltfrequenz der getakteten Energiereglereinheit (4) einzustellen und/oder Schaltphasen der ersten getakteten Halbbrückenschaltung (Tp1, Tp2, Dp1, Dp2) und der zweiten getakteten Halbbrückenschaltung (Tp3, Tp4, Dp3, Dp4) unabhängig von Schaltphasen der getakteten Energieregiereinheit (4) einzustellen.

## Claims

1. DC-DC converter (1, 1', 1", 1"'), comprising:
- an output terminal, wherein the output terminal comprises a first output terminal pin (2) and a second output terminal pin (3),
- a number of rectifier elements (D1, D2; Td1, Td2),
- a voltage limiting unit (3) comprising an electrical energy store (C1), wherein the voltage limiting unit (3) is designed to limit voltages across the rectifier elements (D1, D2; Td1, Td2),
- a clocked energy regulator unit (4) which is designed to regulate at a setpoint value energy which is stored in the electrical energy store (C1), wherein the clocked energy regulator unit (4) comprises a DC chopper (5) which is designed to transmit energy which is stored in the electrical energy store (C1) to the output terminal,
- a transformer (6) comprising a first secondary winding (6a) and a second secondary winding (6b), wherein the rectifier elements (D1, D2; Td1, Td2) are designed to rectify voltages across the first secondary winding (6a) and the second secondary winding (6b),
- an inductive component (L1),
**characterized in that**
- a first terminal of the first secondary winding (6a) and a first terminal of the second secondary winding (6b) are electrically connected to the second output terminal pin (3),
- wherein a first rectifier element (D1) and the inductive component (L1) are connected between a second terminal of the first secondary winding (6a) and the first output terminal pin (2), and
- wherein a second rectifier element (D2) is connected between a second terminal of the second secondary winding (6b) and a connecting node of the first rectifier element (D1) and of the inductive component (L1),
- wherein the voltage limiting unit (3) comprises:
- a first diode (D3) and
- a second diode (D4),
- wherein the electrical energy store (C1) is a capacitor,
- wherein the anode of the first diode (D3) and the anode of the second diode (D4) are electrically connected to a first terminal of the capacitor (C1),
- wherein the cathode of the first diode (D3) is electrically connected to the second terminal of the first secondary winding (6a),
- wherein the cathode of the second diode (D4) is electrically connected to the second terminal of the second secondary winding (6b), and
- wherein a second terminal of the capacitor (C1) is electrically connected to a connecting node of the first rectifier element (D1), the second rectifier element (D2) and the inductive component (L1),
- wherein the energy regulator unit (4) comprises a decoupling diode (D5) and a charge transfer capacitor (C2),
- wherein the cathode of the decoupling diode (D5) is electrically connected to the anode of the first diode (D3) and to the anode of the second diode (D4),
- wherein a first terminal of the charge transfer capacitor (C2) is electrically connected to the anode of the decoupling diode (D5),
- wherein a second terminal of the charge transfer capacitor (C2) is electrically connected to the second output terminal pin (3),
- wherein a first input terminal pin of the DC chopper (5) is electrically connected to the anode of the decoupling diode (D5), and
- wherein a second input terminal pin of the DC chopper (5) is electrically connected to the first terminal of the first secondary winding (6a), to the first terminal of the second secondary winding (6b) and to the second output terminal pin (3).

2. DC-DC converter (1, 1', 1", 1"') according to any of the preceding claims, **characterized in that**
- the rectifier elements (D1, D2, Td1, Td2) are diodes or transistors.

3. DC-DC converter (1, 1', 1", 1"') according to claim 1 or 2, **characterized in that**
- the transformer (6) has at least one primary winding (6c, 6d) and
- the DC-DC converter (1, 1', 1", 1"') has at least one clocked half-bridge circuit (Tp1, Tp2, Dp1, Dp2; Tp3, Tp4, Dp3, Dp4) which is designed to apply a voltage which varies over time or a current which varies over time to the at least one primary winding (6c, 6d),
- wherein the DC-DC converter (1, 1', 1", 1'") is designed to set a switching frequency of the at least one half-bridge circuit (Tp1, Tp2, Dp1, Dp2; Tp3, Tp4, Dp3, Dp4) independently of a switching frequency of the clocked energy regulator unit (4) and/or to set switching phases of the at least one half-bridge circuit (Tp1, Tp2, Dp1, Dp2; Tp3, Tp4, Dp3, Dp4) independently of switching phases of the clocked energy regulator unit (4).

4. DC-DC converter (1, 1', 1", 1"') according to claim 1 or 2, **characterized in that**
- the transformer (6) has a first primary winding (6c) and a second primary winding (6d) and
- the DC-DC converter (1, 1', 1", 1'") comprises a first clocked half-bridge circuit (Tp1, Tp2, Dp1, Dp2) and a second clocked half-bridge circuit (Tp3, Tp4, Dp3, Dp4), wherein the first clocked half-bridge circuit (Tp1, Tp2, Dp1, Dp2) is designed to apply a voltage which varies over time or a current which varies over time to the first primary winding (6c), and the second clocked half-bridge circuit (Tp3, Tp4, Dp3, Dp4) is designed to apply a voltage which varies over time or a current which varies over time to the second primary winding (6d),
- wherein the DC-DC converter (1, 1', 1", 1"') is designed to set a switching frequency of the first clocked half-bridge circuit (Tp1, Tp2, Dp1, Dp2) and of the second clocked half-bridge circuit (Tp3, Tp4, Dp3, Dp4) independently of a switching frequency of the clocked energy regulator unit (4) and/or to set switching phases of the first clocked half-bridge circuit (Tp1, Tp2, Dp1, Dp2) and of the second clocked half-bridge circuit (Tp3, Tp4, Dp3, Dp4) independently of switching phases of the clocked energy regulator unit (4).

## Revendications

1. Convertisseur continu-continu (1, 1', 1", 1"'), comportant :
- une borne de sortie, la borne de sortie comportant un premier pôle de borne de sortie (2) et un deuxième pôle de borne de sortie (3),
- un certain nombre d'éléments redresseurs (D1, D2 ; Td1, Td2),
- une unité de limitation de tension (3) comportant un dispositif d'accumulation d'énergie électrique (C1), l'unité de limitation de tension (3) étant conçue pour limiter des tensions sur les éléments redresseurs (D1, D2 ; Td1, Td2),
- une unité de régulation d'énergie cadencée (4) conçue pour réguler à une valeur de consigne l'énergie accumulée dans le dispositif d'accumulation d'énergie électrique (C1), l'unité de régulation d'énergie cadencée (4) comprenant un régulateur de courant continu (5) conçu pour transmettre à la borne de sortie l'énergie accumulée dans le dispositif d'accumulation d'énergie électrique (C1),
- un transformateur (6) comportant un premier enroulement secondaire (6a) et un deuxième enroulement secondaire (6b), les éléments redresseurs (D1, D2 ; Td1, Td2) étant conçus pour redresser des tensions au niveau du premier enroulement secondaire (6a) et du deuxième enroulement secondaire (6b),
- un composant inductif (L1), **caractérisé en ce que**
- une première borne du premier enroulement secondaire (6a) et une première borne du deuxième enroulement secondaire (6b) sont reliées électriquement au deuxième pôle de borne de sortie (3),
- un premier élément redresseur (D1) et le composant inductif (L1) étant insérés entre une deuxième borne du premier enroulement secondaire (6a) et le premier pôle de borne de sortie (2), et
- un deuxième élément redresseur (D2) étant inséré entre une deuxième borne du deuxième enroulement secondaire (6b) et un noeud de connexion du premier élément redresseur (D1) et du composant inductif (L1),
- l'unité de limitation de tension (3) comprenant :
- une première diode (D3) et
- une deuxième diode (D4),
- le dispositif d'accumulation d'énergie électrique (C1) étant un condensateur,
- l'anode de la première diode (D3) et l'anode de la deuxième diode (D4) étant reliées électriquement à une première borne du condensateur (C1),
- la cathode de la première diode (D3) étant reliée électriquement à la deuxième borne du premier enroulement secondaire (6a),
- la cathode de la deuxième diode (D4) étant reliée électriquement à la deuxième borne du deuxième enroulement secondaire (6b), et
- une deuxième borne du condensateur (C1) étant reliée électriquement à un noeud de connexion du premier élément redresseur (D1), du deuxième élément redresseur (D2) et du composant inductif (L1),
- l'unité de régulation d'énergie (4) comprenant une diode de découplage (D5) et un condensateur de transfert de charge (C2),
- la cathode de la diode de découplage (D5) étant reliée électriquement à l'anode de la première diode (D3) et à l'anode de la deuxième diode (D4),
- une première borne du condensateur de transfert de charge (C2) étant reliée électriquement à l'anode de la diode de découplage (D5),
- une deuxième borne du condensateur de transfert de charge (C2) étant reliée électriquement au deuxième pôle de borne de sortie (3),
- un premier pôle de borne d'entrée du convertisseur continu-continu (5) étant relié électriquement à l'anode de la diode de découplage (D5), et
- un deuxième pôle de borne d'entrée du convertisseur continu-continu (5) étant relié électriquement à la première borne du premier enroulement secondaire (6a), à la première borne du deuxième enroulement secondaire (6b) et au deuxième pôle de borne de sortie (3).

2. Convertisseur continu-continu (1, 1', 1", 1"') selon l'une des revendications précédentes, **caractérisé en ce que**
- les éléments redresseurs (D1, D2 ; Td1, Td2) sont des diodes ou des transistors.

3. Convertisseur continu-continu (1, 1', 1", 1"') selon la revendication 1 ou 2, **caractérisé en ce que**
- le transformateur (6) comporte au moins un enroulement primaire (6c, 6d), et
- le convertisseur continu-continu (1, 1', 1", 1"') comporte au moins un circuit en demi-pont cadencé (Tp1, Tp2, Dp1, Dp2 ; Tp3, Tp4, Dp3, Dp4) qui est conçu pour appliquer une tension variant dans le temps ou un courant variant dans le temps à au moins un enroulement primaire (6c, 6d),
- le convertisseur continu-continu (1, 1', 1", 1"') étant conçu pour régler une fréquence de commutation dudit au moins un circuit en demi-pont (Tp1, Tp2, Dp1, Dp2 ; Tp3, Tp4, Dp3, Dp4) indépendamment d'une fréquence de commutation de l'unité de régulation d'énergie cadencée (4) et/ou pour régler des phases de commutation dudit au moins un circuit en demi-pont (Tp1, Tp2, Dp1, Dp2 ; Tp3, Tp4, Dp3, Dp4) indépendamment de phases de commutation de l'unité de régulation d'énergie cadencée (4).

4. Convertisseur continu-continu (1, 1', 1", 1"') selon la revendication 1 ou 2, **caractérisé en ce que**
- le transformateur (6) comporte un premier enroulement primaire (6c) et un deuxième enroulement primaire (6d) et
- le convertisseur continu-continu (1, 1', 1", 1"') comporte un premier circuit en demi-pont cadencé (Tp1, Tp2, Dp1, Dp2) et un deuxième circuit en demi-pont cadencé (Tp3, Tp4, Dp3, Dp4), le premier circuit en demi-pont cadencé (Tp1, Tp2, Dp1, Dp2) étant conçu pour appliquer une tension ou un courant variant dans le temps au premier enroulement primaire (6c) et le deuxième circuit en demi-pont cadencé (Tp3, Tp4, Dp3, Dp4) étant conçu pour appliquer une tension ou un courant variant dans le temps au deuxième enroulement primaire (6d),
- le convertisseur continu-continu (1, 1', 1", 1'") étant conçu pour régler une fréquence de commutation du premier circuit en demi-pont cadencé (Tp1, Tp2, Dp1, Dp2) et du deuxième circuit en demi-pont cadencé (Tp3, Tp4, Dp3, Dp4) indépendamment de la fréquence de commutation de l'unité de régulation d'énergie cadencée (4) et/ou pour régler des phases de commutation du premier circuit en demi-pont cadencé (Tp1, Tp2, Dp1, Dp2) et du deuxième circuit en demi-pont cadencé (Tp3, Tp4, Dp3, Dp4) indépendamment de phases de commutation de l'unité de régulation d'énergie cadencée (4).
